# EUROPEAN PATENT APPLICATION

(11) **EP 0 905 761 A2**
(43) Date of publication of application: **31.03.1999**
(21) Application number: 98306902.2
(22) Date of filing: 27.08.1998
(51) Int. Cl.: H01L 21/336, H01L 29/78, H01L 29/786

(54) **Method of manufacturing a field effect transistor**

(30) Priority: 29.08.1997 US 57194 P
(71) Applicant: TEXAS INSTRUMENTS INC., Dallas, Texas 75243 (US)
(72) Inventor: Houston, Theodore W., Richardson, TEXAS 75080 (US)
(74) Representative: Potter, Julian Mark

(57) **Abstract**

A field effect transistor component is fabricated by forming disposable gate structure on a semiconductor substrate and forming source/drain electrodes in a region not shadowed by the disposable gate structure. A dielectric material (104) is applied to the semiconductor substrate (100) and to the disposable gate structure (101). The disposable gate structure (101) is exposed and removed leaving an aperture (105) in the dielectric material (104). Ions (108) are implanted through the aperture (105) in the region (106, 107) of the semiconductor substrate previously shadowed by the disposable gate structure, thereby forming an aligned back gate in the semiconductor substrate. The aperture is then filled with conducting material (110) thereby forming the gate structure for the transistor component. The back gate region created by the implanted ions can be narrowed by forming sidewalls (201) on the aperture (105). The present technique for fabricating a field effect transistor can applied to semiconductor-on-insulator structures. In this embodiment, the ions resulting in the back gate structure are implanted in a doped region in a (BOX) semiconductor layer (415) or in the insulating substrate (600).

## Description

### FIELD OF THE INVENTION

This invention relates generally to the fabrication of semiconductor devices, and more particularly, to the fabrication of integrated circuit semiconductor devices which have a buried, doped region such as a back gate region. The doped region is aligned with respect to selected elements of the component.

### DESCRIPTION OF THE RELATED ART

It is known in the prior art to provide a field-effect transistor in which a punch-through implant is aligned by techniques described in US Patent No. 5,599,728, issued February 4, 1997 in the name of Chenming Hu et al. In this reference, an aperture is formed in a layer above the semiconductor substrate, the aperture being positioned above the region in which the punch-through implant is to be formed. An ion beam is used to create the doped region under the aperture. The gate structure is formed in the aperture and the source/drain terminal formed in the regions outside of the aperture. This technique provides an implanted and aligned back gate, but the back gate typically extends in the region under the source drain terminal providing undesirable capacitance therebetween and increasing the opportunity for leakage current between the back gate region and the source/drain terminals. The extension of the punch-through implant region is in part due to the straggle of the implanted ions, but this extension is exacerbated by diffusion during the gate oxidation and during the source-drain anneal.

A need has therefore been felt for apparatus and a related method to fabricate a field effect transistor in which the punch-through implant region has a reduced overlap with the source/drain terminal regions. A similar need is felt for the body contact alignment and back gate alignment for a silicon-on-insulator (SOI) transistor.

### SUMMARY OF THE INVENTION

The aforementioned and other features are accomplished, by fabricating appropriately doped regions for source/drain terminals in the vicinity of a region shadowed by a disposable gate terminal. The disposable gate region and the source/drain regions that extend from the disposable gate terminal are covered with a protective material. The protective material and the disposable gate terminal are planarized generally parallel to the substrate. The disposable gate material is then removed leaving an aperture in the protective material. An ion beam is used to implant a punch-through implant region beneath a conducting region, the conducting region electrically coupling the source/drain terminals. The aperture is filled with a conducting material, that forms a transistor gate element. The punch-through implant region is directly beneath the gate terminal and is aligned therewith. The punch-through implant region can be further centered by forming sidewall regions on the walls of the aperture resulting from the removal of the disposable gate. A similar procedure can be performed on a silicon-on-insulator structure to provide an aligned, doped region under the gate terminal.

### BRIEF DESCRIPTION OF THE DRAWINGS

Embodiments of the present invention will now be further described, by way of example, with reference to the accompanying drawings in which:
Figures 1A - 1H illustrate steps in fabricating an aligned back-gate;
Figures 2A - 2C illustrate a method for providing a smaller back gate region:
Figures 3A - 3C show a technique for improving the prior art method for providing a self-aligned field effect transistor back gate.
Figures 4A - 4C illustrate a prior art technique for forming a buried oxide structure;
Figures 4G - 4L illustrate a novel technique for forming a buried oxide structure;
Figure. 4M illustrates the use of ion implantation to provide a technique for providing a self-aligned back gate in a buried oxide structure;
Figure 5 illustrates how the techniques of self-aligned punch-through ion implantation can provide a local well (doped region) imbedded in a deep well in the substrate;
Figures 6A - 6D illustrate a first two-gate material layer technique for providing a self-aligned punch-through ion implantation region;
Figures 7A - 7D illustrate a second two-gate material layer technique for providing a self-aligned punch-through ion implantation region; and
Figures 8A - 8F illustrates a lift-off process for providing an integrated circuit transistor having a self-aligned back gate.

### DETAILED DESCRIPTION OF THE DRAWINGS

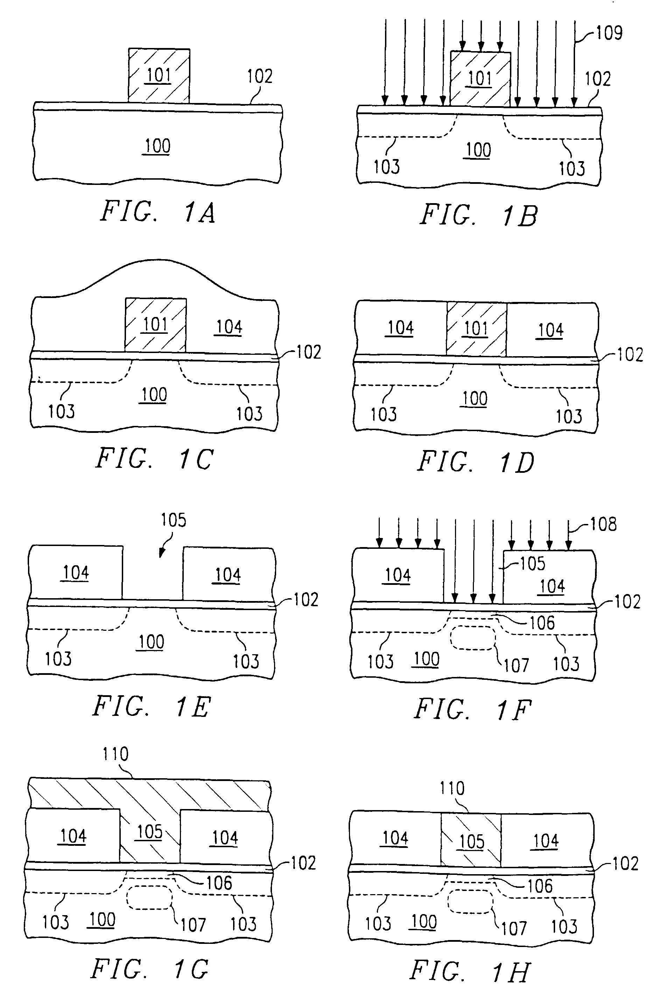

Referring to Figs. 1A through 1H, preferred steps for fabricating a field effect transistor with a self-aligned punch-through region, are shown. In Fig. 1A, a disposable gate 101, formed from a material such as polysilicon or silicon nitride, is formed over a gate oxide layer 102, the gate oxide layer formed on a substrate 100. In Fig. 1B, the substrate 100 and disposable gate 101 have an ion beam 109 applied thereto. The ion beam 109 implants ions in source/drain electrode regions 103 in the substrate 100. The source/drain regions 103 are formed in portions of the substrate not shadowed by the disposable gate 101. Optionally, a sidewall structure can be formed on the disposable gate (not shown) further to space apart the source and drain implant regions. Arsenic and phosphorous ions can be used to form the electrodes in n-channel field effect transistors, while boron and boron fluoride ions can be used to form electrodes in p-channel field effect transistors.

Following the source-drain implant, an anneal step is performed.

After the formation of the source/drain electrodes 103, gate oxide 100 and the disposable gate 101 have a dielectric material 104 applied thereto as shown in Fig. 1C. In Fig. 1D, the dielectric material 104 as well as the disposable gate 101 are planarized (i.e., a surface generally parallel with the substrate 100 is formed) with the result that a top portion of the disposable gate 101 is exposed. The exposed disposable gate 101 is removed leaving an aperture 105 as shown in Fig. 1E. In Fig. 1F, the resulting structure is exposed to ion beam 108. The ion beam 108 results in formation of the channel implant 106 and in the formation of a local well (punch-through implant) region 107.

Optionally, the initial gate oxide can be removed and the final gate oxide formed. In Fig. 1G, a layer of gate material 110 (e.g., titanium nitride) is deposited in the aperature in the dielectric material 104 remaining after the disposable gate 101 has been removed and is deposited on the dielectric material 104. In Fig. 1H, the gate material is removed from the surface of the dielectric material 104 leaving only the conducting material 110 now in the aperture 105. The gate of the transistor component is now exposed and is available for coupling to conducting leads. The conducting leads applying control signals to the gate element of the transistor component.

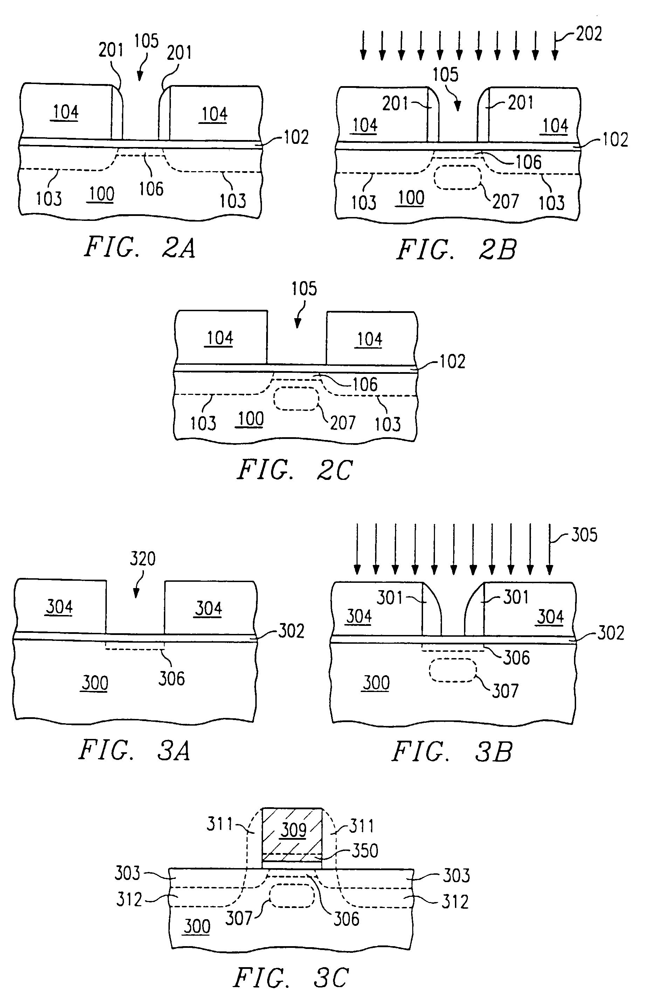

Referring to Fig. 2A through Fig. 2C, a technique for providing a more localized back gate is shown. This procedure can replace the process step(s) illustrated in Fig. 1E. In Fig. 2A, after the channel implant, sidewalls 201 are formed on walls of the aperature 105 formed by the removal of the disposable gate 101 (cf. Fig. 1F). Ion beam 202 then forms back gate region 207 in Fig. 2B. In Fig. 2C, the sidewalls 201 are removed. The process then continues as shown in Fig. 1F wherein a gate electrode for the transistor component is formed.

Referring to Fig. 3A through Fig. 3C, a technique is illustrated for insuring that the separation of the back gate region from the source/drain electrodes is maintained for fabrication of a field effect transistor. Referring to Fig. 3A, in a prior art process, a gate oxide layer 302 is formed on a substrate 300. A dielectric layer 304 is formed on gate oxide layer 302. The dielectric layer 304 has aperture 320 in a position relative to substrate 300 where the gate structure will eventually be positioned. A channel implant 306 is formed under the aperture 320. In Fig. 3B, sidewalls 301 are formed on the walls of the aperature 320. Ions 305 are applied to the substrate/dielectric combination and a punch-through implant region 307 is formed in the substrate 300. In Fig. 3C, the sidewalls 301 are removed and the aperture 320 is filled with a conducting material which will be the gate structure 309. Source/drain electrodes 303 are formed in the region having a boundary formed by the shadow of the gate structure 309. The sidewalls 301 cause the back gate rear to be sufficiently far from the boundary gate structure 309 shadow that even diffusion by the source/drain electrodes 303 will not result in contact.

Referring once again to Fig. 3C, the dotted lines indicate a second approach to separating the source/drain electrodes 303 from the back gate 307. Sidewalls 311 are formed around the gate structure 309 either prior to formation of the source/drain electrodes or after the formation of the source drain electrodes 303. If the sidewalls 311 are formed before the formation of the source/drain electrodes, then the source/drain electrodes 312 can be separated from the back gate 307 without the use of sidewalls 301 (shown in Fig. 3B). Similarly, the sidewalls 311 can be formed after the (relatively more lightly doped) source/drain electrodes 303 are formed. In this process, the source/drain electrodes 312 combine with source drain/electrodes 303 to form the transistor source/drain electrodes.

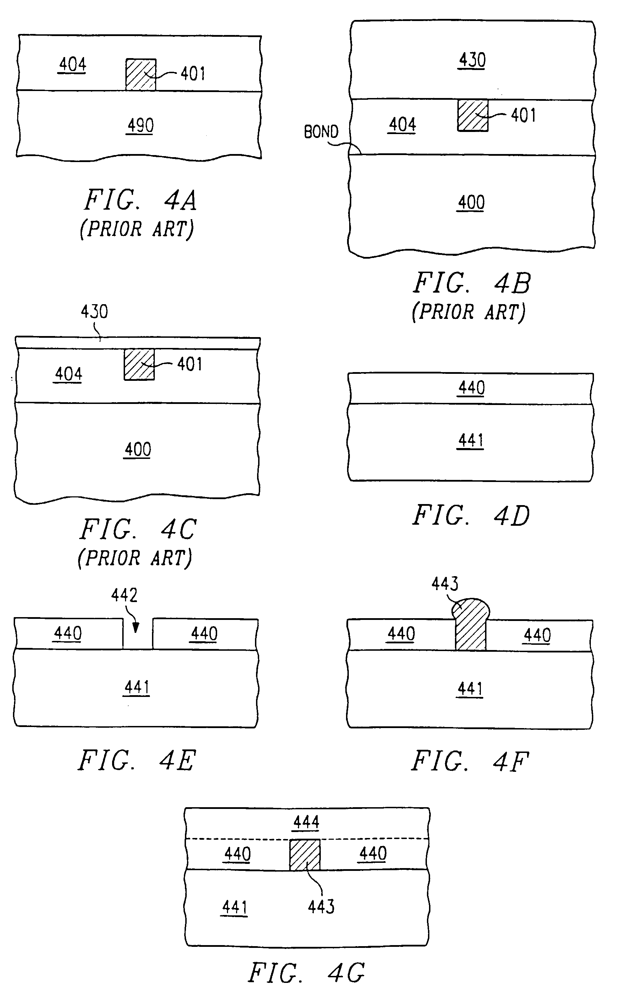

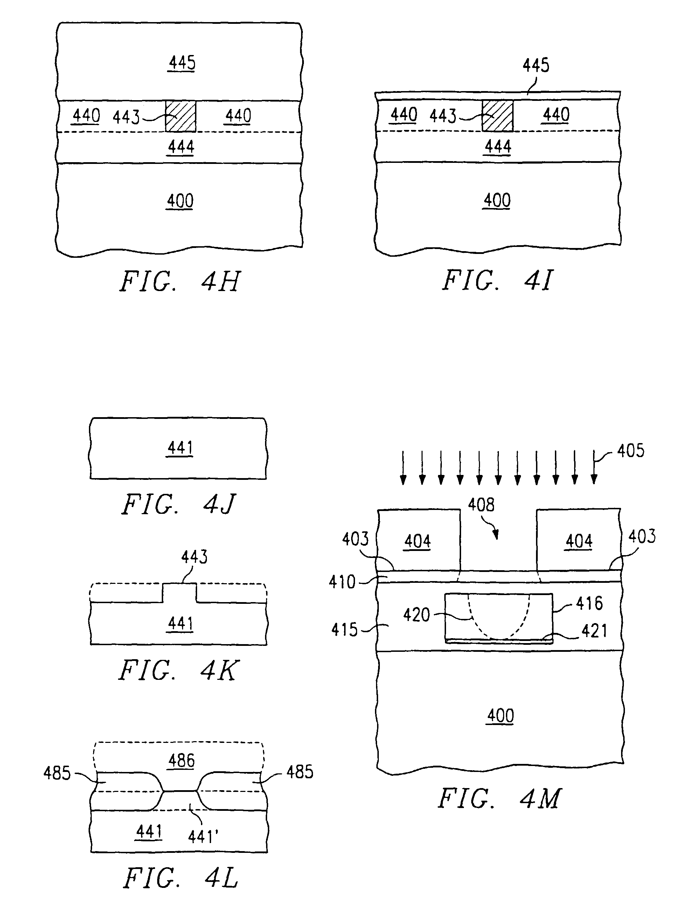

Referring next to Fig. 4A through Fig. 4C, a prior art process for performing a back contact procedure to provide a buried oxide structure is shown. In Fig. 4A,, a patterning technique is used to provide a polysilicon structure 401 on a base material 490. A dielectric layer (e.g., SiO₂) 404 is formed over the polysilicon structure 401 and the base material 490. The dielectric layer 404 is then planarized. The dielectric layer 404 and the polysilicon structure 401 are then removed from the base material 490. In Fig. 4B, the planarized surface of the dielectric layer 404 is bonded to a substrate wafer 400 and a second dielectric layer is formed on the surface of the dielectric layer 404 and the polysilicon structure 401. The thickness of the second dielectric layer 430 is reduced in Fig. 4C, resulting in a buried oxide structure.

In Fig. 4D through 4G, a process for providing a buried oxide structure, is shown. In Fig. 4D, a SiO₂ layer 440 is formed on the surface of a silicon wafer 441. In Fig. 4E, an aperture 442 is formed, the aperture extending to the silicon wafer 441, for example, by patterning and etching the dielectric (SiO₂) layer 440. In Fig. 4F, silicon material 443 is formed in the aperture, for example, by selective epitaxial growth. In Fig. 4G, the silicon material 443 and the dielectric layer 440 are planarized and a second dielectric layer is formed on the planarized surface. In Fig. 4H, the surface of the second dielectric layer 444 is planarized, the structure including the dielectric layers 440 and 444 and the silicon material 443 is removed from the silicon wafer 441 and the planarized surface of dielectric layer 444 is bonded to substrate wafer 400. A third dielectric layer 445 is applied to the surfaces of dielectric layer 440 and silicon material 443. In Fig. 41, the thickness of the third dielectric layer is reduced.

Referring to Fig. 4J through Fig. 4L, two techniques for providing a buried oxide structure from a silicon wafer 441 are shown. In Fig. 4J, the surface of the silicon wafer is patterned and etched, for example, to form the structure 443 which will become, after deposition of a dielectric layer, the basis for the buried oxide layer. In Fig. 4L, silicon oxide regions 485 are selectively grown on the surface of the silicon wafer 441. After the growth of the silicon oxide regions 485, an additional silicon oxide layer 486 is formed over the silicon oxide regions 485 and the exposed surface of the silicon wafer 441. The silicon regions 485 and the silicon region 441' are separated from the remainder of the silicon wafer 441 to form the basis of the buried oxide structure.

Referring next to Fig. 4M, the process for punch-through implant of ions in a buried oxide structure when the transistor structure is formed on an insulating material substrate (also known as an SOI structure) is shown. Buried oxide (BOX) layer 415 is formed on semiconductor substrate 400 as described above. The BOX layer 415 includes the silicon region 416. Formed on BOX layer 415 is silicon layer 410. The silicon layer 410 includes the source/drain electrodes 403. Positioned over the silicon layer 410 is a dielectric material 404 which includes an aperture in a position where the gate of the transistor element will be positioned. Ions 405 are implanted through the aperture in the dielectric material 404 and change the doping of a portion 420 of doped region 416. The region 420 becomes the back gate for the transistor component. The aperture in the dielectric material 404, in process steps illustrated in Fig. 1G and Fig. 1H is filled with conducting material and is the gate structure for the transistor component.

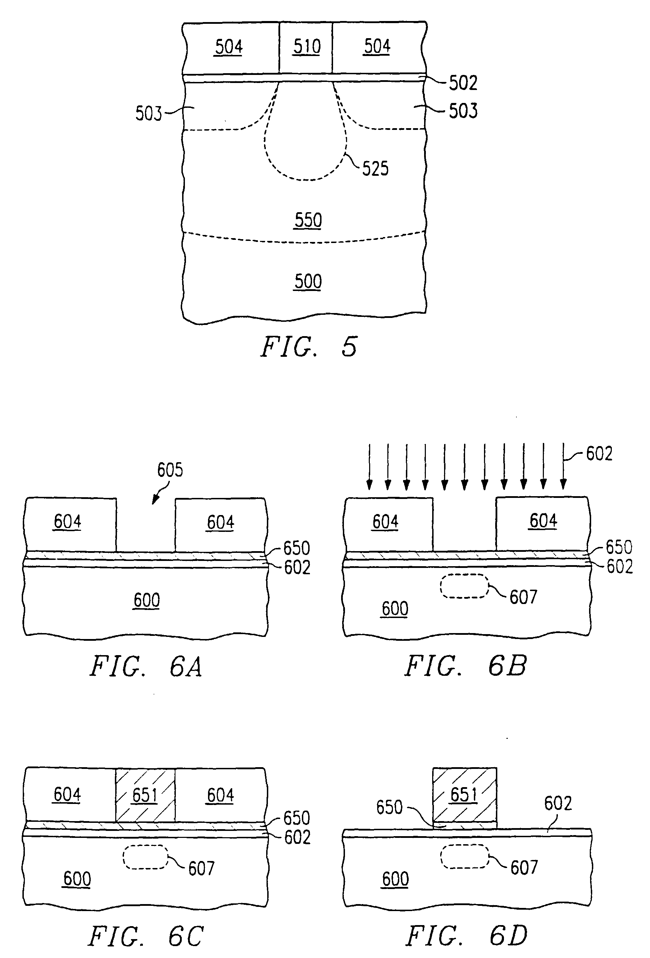

Referring to Fig. 5, the result of using the process for punch-through implant, described above, is shown in Fig. 5. The source/drain structures 503 of the transistor element (having gate structure 510) are shown in a deep well portion 550 of the substrate 500. By the previously described techniques of punch-through ion implant, a local well can be provided. The local well can provide a region of relatively lower resistivity compared to the deep well in which the transistor element is fabricated. In operation, individual local wells within a common deep well can be maintained at different voltages.

Referring to Fig. 6A through Fig. 6C, a two gate layer process for forming a self-aligned punch-through implant region element is shown. A substrate material 600 (typically a silicon wafer) has a gate oxide 602 layer formed thereon. On the gate oxide layer 602, a first gate layer 651 is formed. A dielectric (or gate patterning) layer 604 has been formed by a different etch selectivity, e.g., SiO₂ and a gate area 605 is removed from the dielectric layer 604 in Fig. 6A. In Fig. 6B, a self-aligned implant of ions 602 to form punch-through implant region 607 is performed. In Fig. 6C, a second gate layer 651 is formed over dielectric layer and gate area 605. The surface is planarized to provide the device gate. The dielectric layer 604 and the first gate layer 650 are removed except where the first gate layer 651 is shadowed by the remaining (i.e., after planarization as shown in Fig. 6C) second gate layer 651.

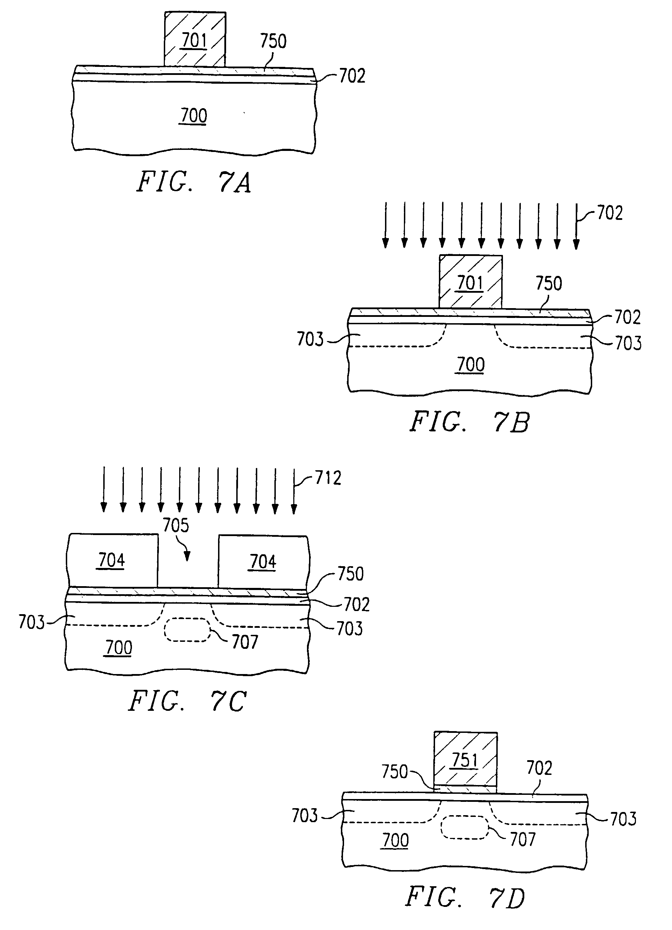

Referring to Fig. 7A through Fig. 7B, a two gate layer process for forming transistor element and a self-aligned punch-through implant region are shown. In Fig. 7A, a gate oxide layer 702 is formed on a substrate 700. A first gate layer 750 is formed on the gate oxide layer 702. A disposable gate element 701 is formed, typically by selective etching, over the region wherein the gate electrode will be positioned. In Fig. 7B, an ion beam 702 is used to form the source/drain electrodes 703, the disposable gate element 701 preventing the ions 702 from being implanted in the region thereunder. In Fig. 7C, a dielectric layer 704 is formed over the disposable gate 701 and the first gate layer 702. The dielectric layer 704 is planarized, exposing the disposable gate 701. The disposable gate 701 is selectively removed, leaving aperture 705 in the dielectric material 704. An ion beam 712 is applied to the device forming the self-aligned punch-through implant region 707. In Fig. 7D, a second gate layer 751 is applied to the dielectric layer 704 and into the aperture 705. After planarization in which the dielectric layer 704 is exposed surrounding the second gate layer 751, the dielectric layer 704 and the portion of the first gate layer 750 not protected (shadowed) by the remaining second gate layer 751 are selectively removed. The remaining first gate layer 750 and the remaining second gate layer 751 provide the gate structure for the transistor element.

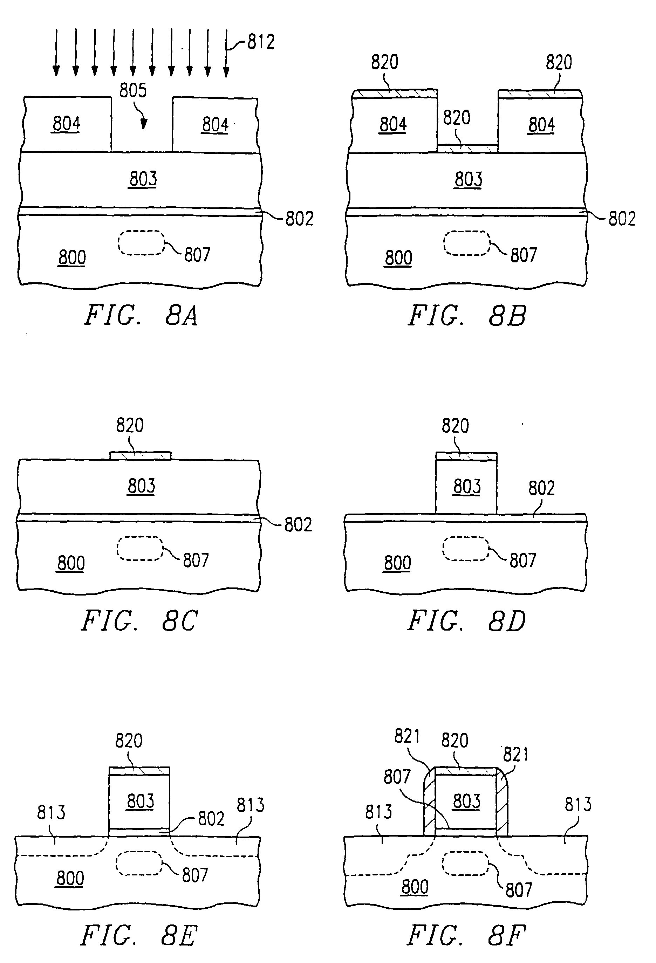

Referring next to Fig. 8A through Fig. 8F, an alternative technique for fabricating an integrated circuit transistor element having a self-aligned (punch-through ion implanted) back gate is shown. In Fig. 8A, a gate oxide layer 802 is formed on substrate 800. A gate material layer 803 is formed on the gate oxide layer 802. A dielectric layer 804 is formed on gate material layer 803. The dielectric layer 804 is patterned to have an aperture over the portion of the gate material layer 803 which will form the gate electrode of the transistor element. An ion beam 812 provides a ion implantation region 807 aligned with the aperture 805. In Fig. 8B, a protective layer 820 is applied to the surface of dielectric layer 804 and to the surface of the gate material layer 803 exposed by the aperture 805. In Fig. 8C, the dielectric layer 804 and the portion of the protective layer 820 on the surface of dielectric layer 804 are removed. The portion of the protective layer 820 on the surface of the gate material layer 803 defined by aperture 805 remains. In Fig. 8D, the portion of the gate material layer 803 not shadowed by the remaining protective layer 820 is selectively removed. In Fig. 8E, the portion of the gate oxide 802 not shadowed by the remaining gate material layer 803 is removed. In addition, the source and drain electrodes 813 of the transistor element are formed by ion implantation outside of the region shadowed by the remaining protective layer 820. In Fig. 8F, sidewalls 821 have been added to the structure provided the remaining protective layer 820, the remaining gate material layer 803, and the remaining gate oxide layer 802. The source/drain electrodes 813 can be more heavily doped by additional ion implantation. The side walls 821 protect the ion implantation region 807 from the heavier doping levels of the extended source/drain electrodes.

Referring once again to Fig. 1A through Fig. 1H, the preferred process results in an aligned back gate for the transistor component fabricated thereby. The back gate region prevents punch-through between the electrode regions (103). The aligned back gate region can be separated from the electrode regions (103) by processes illustrated in Fig. 2A through Fig. 2C and in Fig. 3A through Fig. 3C.

In Fig. 4M, the processes described in detail in previous Figures are applied to a different semiconductor structure, the silicon-on-insulator devices. In this application, the back gate structure serves as a gate structure. Optionally, the back gate structure 416 can be composed of silicon. The silicon can be lightly doped oppositely to the self-aligned implant region 420. For example, back gate structure 416 can be a lightly-doped p-type region, e.g., with boron, prior to a self aligned n-type implant, e.g., arsenic. The back gate structure 416 can optionally be backed with a conducting material to form a backing layer 421, e.g., a metal or a silicide. The backing layer 421 is preferably a good implant ion stopping material, e.g., tungsten, resulting in an implant ion accumulation in back gate structure 416.

Referring once again to Fig. 6A through Fig. 6D and Fig. 7A through Fig. 7D, a gate oxide is formed, a first gate layer is formed to protect the gate oxide, and the punch-through ion implant is implemented. Following the formation of the punch-through ion implant region, a second gate layer is formed. This process of providing two gate layers has the advantage that the ions penetrate a thinner material than would be the situation if the entire gate layer were formed initially. In addition, this process has the advantage that implanted ions are not exposed to the thermal cycle of growing the gate oxide. Preferably, the first and second gate layers have different etch properties, however, this difference in properties is not necessary. A variety of combinations of first and second layer gate materials, including polysilicon/metal, metal-1/metal-2, and compounds such as TiN/W can be used. Amorphous silicon may be used instead of polysilicon. Either or both of the first and second gate layers can be multiple layers of materials, or the first and second gate layers can be formed from the same materials. The gate may comprise additional layers.

A preferred aspect is that the implant process is done through the first layer and the second layer is formed after the implant process. Further, the patterning of the second gate layer can be self-aligned with respect to the ion implantation. In addition, the patterning of the first gate layer may be aligned to the pattern of the second gate layer.

As will be clear to those skilled in the art, the punch-through implant region, the local well region, the body contact region, and the back gate region all describe a localized ion implant region.

While the use of polysilicon has been previously proposed for a back-body contact, polysilicon has the disadvantage that diffusion junctions can have a relatively high leakage, increasing the importance of self-alignment of the implanted ion regions. Forming back-body contacts with single crystal silicon, either by selective epitaxial processes or by etching of the silicon surface, will reduce the probability of high junction leakage current. Self-alignment of the implanted ion regions is important to reduce the junction capacitance of the device.

While the invention has been described with particular reference to the preferred embodiment, it will be understood by those skilled in the art that various changes may be made and equivalents substituted for elements of the preferred embodiment without departing from the invention. In each of the steps providing the self-alignment for example, additional masking steps may be provided in addition to the specified steps providing the self-alignment process without departing from the scope of the present invention. Specifically, the implant region can self-aligned with respect to a portion of the gate pattern as limited by the moat pattern. In addition, many modifications may be made to adapt a particular situation and material to a teaching of the present invention without departing from the essential teachings of the present invention.

The scope of the present disclosure includes any novel feature or combination of features disclosed therein either explicitly or implicitly or any generalisation thereof irrespective of whether or not it relates to the claimed invention or mitigates any or all of the problems addressed by the present invention. The applicant hereby gives notice that new claims may be formulated to such features during the prosecution of this application or of any such further application derived therefrom. In particular, with reference to the appended claims, features from dependent claims may be combined with those of the independent claims and features from respective independent claims may be combined in any appropriate manner and not merely, in the specific combinations enumerated in the claims.

## Claims

1. A method for fabricating a field effect transistor, comprising the steps of:
implanting a source/drain region in a substrate;
forming a gate oxide region on said substrate;
forming a dielectric layer having at least one aperture;
implanting ions through at least one said aperture; and
forming a gate in said aperture.

2. The method of Claim 1, wherein said step of implanting further comprises annealing said source/drain region in said substrate.

3. The method of Claim 1 or Claim 2, wherein said step of implanting ions is performed after at least one of said steps of forming a gate oxide and implanting.

4. The method of any preceding Claim, further comprising the step of forming a disposable gate in said aperture.

5. A field effect transistor, comprising:
a drain region separate from a source region;
a gate region electrically coupling said source and said drain region; and
an implant region, that is vertically aligned with said gate region, said implant region having substantially no vertical overlap with said source region and said drain region.

6. A method for fabricating a field effect transistor in a surface region of semiconductor substrate, said method comprising the steps of:
forming a disposable gate structure disposed outwardly from a region of said semiconductor substrate;
fabricating source/drain electrodes in said semiconductor substrate outside of said region of said semiconductor substrate;
forming a dielectric material over said semiconductor substrate and said disposable gate structure;
exposing and removing said disposable gate structure to form an aperture outwardly from said region of said semiconductor substrate;
implanting ions through said aperture in said region to form a local ion implant region in said region; and
forming a gate structure in said aperture.

7. A transistor fabricated in a silicon device layer, said silicon device layer formed on a first dielectric layer, said transistor comprising:
a drain region in said silicon device layer;
a source region in said silicon device layer;
a channel region extending between said source region and said channel region;
a front gate disposed outwardly from said silicon layer, and separated from said channel region by a second dielectric layer; and
a body contact region comprising crystal silicon contiguous with said silicon device layer in said channel region and extending into said first dielectric layer.

8. A method for providing a transistor fabricated in a silicon device layer, said silicon device layer formed on a first dielectric layer, said method comprising the steps of:
forming a drain region in said silicon device layer;
forming a source region in said silicon device layer;
forming a channel region extending between said source region and said channel region;
forming a front gate disposed outwardly from said silicon layer, and separated from said channel region by a second dielectric layer; and
forming a body contact region comprising crystal silicon contiguous with said silicon device layer in said channel region and extending into said first dielectric layer.

9. A method of forming a transistor having a self-aligned implant region, comprising the steps of:
forming a drain region and a source region in a semiconductor substrate;
forming a channel region extending between said source region and said drain region;
forming a dielectric layer disposed outwardly from said semiconductor substrate;
forming a first gate layer disposed outwardly from said dielectric layer;
forming a selective implantation pattern disposed outwardly from said first gate layer, said selective implantation pattern including a window region disposed outwardly from said channel region;
forming a self-aligned implant region by implanting ions into said semiconductor substrate through said window portion of said selective implantation pattern;
forming second gate layer approximately coextensive with said window portion of said selective implantation pattern and disposed outwardly from the first gate layer, and
etching said first gate layer such that said second gate layer such as a mask to form a gate disposed inwardly from said second gate layer and disposed outwardly from said dielectric layer.

10. An integrated circuit transistor, said transistor comprising:
a source region separate from a drain region;
a channel region in a first substrate layer extending between said source region and said drain region;
a front gate disposed outwardly from said first substrate layer, said front gate including two layers of material;
a dielectric layer, separating said front gate from said channel region; and
a self-aligned implant region disposed inwardly from said channel region, said implant region being in approximate vertical alignment with said front gate and having a width approximately equal to that of the front gate.

11. A method of forming a transistor having a self-aligned implant region, said method comprising the steps of:
forming a drain region separate from a source region;
forming a channel region in a semiconductor substrate extending between said source region and said drain region;
forming a buried dielectric layer disposed inwardly from said first semiconductor substrate;
forming a back contact disposed within said buried dielectric layer inwardly from said channel region of said first semiconductor substrate to provide a silicon-on-oxide structure;
forming a dielectric layer disposed outwardly from said first semiconductor substrate of said silicon-on-oxide structure;
forming a gate layer disposed outwardly from said dielectric layer;
forming a selective implantation pattern disposed outwardly from said first gate layer, said selective implantation pattern comprising a window region disposed outwardly from said channel region of said silicon-on-oxide structure and approximately centered over said back contact of said silicon-on-oxide structure;
forming a self-aligned implant region by implanting ions into said back contact of said silicon-on-oxide structure through said implementation pattern;
forming a second gate layer disposed outwardly from the first gate layer coextensive with said window portion of said selective implantation pattern; and
etching said first gate layer using said second gate layer as a mask to form a front gate including said second gate layer and said first gate layer and disposed outwardly from said dielectric layer.
